# EUROPÄISCHE PATENTANMELDUNG

(11) **EP 2 267 901 A1**
(43) Veröffentlichungstag der Anmeldung: **29.12.2010**
(21) Anmeldenummer: 09163249.7
(22) Anmeldetag: 19.06.2009
(51) Int. Cl.: H03M 1/08, H03M 1/06, H03L 1/00

(54) **Verfahren und Vorrichtung zur Umsetzung eines analogen Signals**

(71) Anmelder: Siemens Aktiengesellschaft, 80333 München (DE)
(72) Erfinder: Wagner, Roman, 92224 Amberg (DE)

(57) **Zusammenfassung**

Die Erfindung betrifft ein Verfahren zur Umsetzung eines analogen Signals in ein digitales Signal, wobei das analoge Signal über einen Eingang (3) eines Analog/Digital-Wandlers (2) abgetastet wird, und das abgetastete Signal in das digitale Signal umgesetzt wird, wobei mit einer Taktfrequenz eine Umsetzungszeit bestimmt wird, wobei die Taktfrequenz an eine Störfrequenz eines dem analogen Signal überlagerten Störsignals angepasst wird, und die angepasste Taktfrequenz zur Folge hat, dass die Umsetzungszeit derart angepasst wird, dass bei der Wandlung das Störsignal unterdrückt wird.

## Beschreibung

Die Erfindung betrifft ein Verfahren zur Umsetzung eines analogen Signals in ein digitales Signal, wobei das analoge Signal über einen Eingang eines Analog/Digital-Wandlers abgetastet wird, und das abgetastete Signal in das digitale Signal umgesetzt wird, wobei mit einer Taktfrequenz eine Umsetzungszeit bestimmt wird.

Des Weiteren betrifft die Erfindung eine Vorrichtung zur Umsetzung eines analogen Signals in ein digitales Signal umfassend, einen Analog/Digital-Wandler, einen Eingang für ein analoges Signal und ein Mittel zur Erzeugung einer Taktfrequenz.

Mit einem Analog/Digital-Wandler wird ein analoger, vorzugsweise stetiger Wertebereich auf einen diskreten Zahlenbereich abgebildet. Dieser Zahlenbereich hat in der Regel eine endliche Auflösung, eine begrenzte Anzahl von Schritten zwischen Anfangs- und Endwert. Eine lineare Umsetzung kann in der Praxis nicht ideal geschehen, vielmehr muss man mit möglichen Abweichungen rechnen. Zu statischen Fehlern gehören beispielsweise ein Null-Punkt-Fehler, ein Skalenfaktorfehler, eine Nichtlinearität und mögliche fehlende Messwerte. Störungen und Rauschen beeinflussen die Messung bzw. die Analog/Digital-Wandlung in unregelmäßiger Weise. Daraus entstehende Messunsicherheiten können durch mehrfache Messungen und Mittlungen verringert werden.

Bei der Analog/Digital-Wandlung von Spannungen oder Strömen ist dem Gleichsignal, welches man messen will, häufig ein Wechselanteil überlagert, der beispielsweise von zusätzlichen Signalkomponenten oder von Störungen aus der Netzspannung hervorgerufen wird. Eine Messung des Augenblickwertes des Gleichsignals würde einen stark springenden gewandelten Wert im gesamten Bereich des gestörten Gleichsignals verursachen. Es ist bekannt, mit einem integrierenden Messverfahren, das den mittleren Wert des Gleichsignals während einer Messperiode erfasst, die Störung aus der Netzspannung systematisch zu unterdrücken.

Eine derartige Störunterdrückung muss an die jeweilig herrschende Netzfrequenz angepasst werden, dazu wird ein Analog/Digital-Wandler fest auf die herrschende Netzfrequenz eingestellt.

Nachteilig an heutigen Verfahren und Vorrichtungen zur Umsetzung eines analogen Signals in ein digitales Signal ist es, dass Frequenzschwankungen des Versorgungsnetzes nicht berücksichtigt werden können. Es ist daher die Aufgabe der Erfindung ein Verfahren und eine Vorrichtung anzugeben, um eine Störunterdrückung bei einem Analog/Digital-Wandler zu verbessern.

Für das eingangs genannte Verfahren wird die Aufgabe dadurch gelöst, dass die Taktfrequenz an eine Störfrequenz eines dem analogen Signal überlagerten Störsignals angepasst wird, und die angepasste Taktfrequenz zur Folge hat, dass die Umsetzungszeit derart angepasst wird, dass bei der Umsetzung das Störsignal unterdrückt wird. Beispielsweise ist nach dem Stand der Technik ein Analog/Digital-Wandler auf ein überlagertes Störsignal mit einer Netzfrequenz von 50 Hz eingestellt. Bei einer Messzeit bzw. Umsetzungszeit von beispielsweise 100 µs und vielfachen davon, ergab sich eine relativ gute Störunterdrückung für 50 Hz in Europa und sogar 60 Hz in den USA, aber bei Frequenzschwankungen des Versorgungsnetzes wird diese Störunterdrückung gravierend verschlechtert. Beispielsweise bei autonomen Versorgungsnetzen, wie auf einer Bohrinsel oder auf einem Schiff, kann die Netzfrequenz des Versorgungsnetzes stark schwanken. Dadurch, dass die Taktfrequenz des Analog/Digital-Wandlers an die Störfrequenz des Störsignals angepasst wird, wird die Störunterdrückung weiter verbessert und greift auch bei Frequenzschwankungen des Versorgungsspannungsnetzes. Zu berücksichtigen sind aber auch EMV-bedingte Störspannungseinkopplungen, wie sie beispielsweise durch Antriebe oder Hochfrequenzgeräte in Signalleitungen auftreten können. Diese Störsignale haben dann eine weit größere Frequenzabweichung von der üblichen Netzspannung beispielsweise im den Kilohertzbereich.

Bei einer Ausgestaltung des Verfahrens ist es vorteilhaft, dass aus der Taktfrequenz ein Taktsignal erzeugt wird, und das Taktsignal in Abhängigkeit vom Störsignal ermittelt wird.

Vorzugsweise wird eine Amplitude des Störsignals ermittelt. Insbesondere wird dabei in Abhängigkeit der Amplitude ein Schaltelement betätigt und mittels des Schaltelementes dem Analog/Digital-Wandler entweder aus einer ersten Taktsignalquelle oder aus einer zweiten Taktsignalquelle das Taktsignal zugeführt. Ist beispielsweise der ermittelte Amplitudenwert des Störsignals so gering oder liegt er unter einen bestimmbaren Grenzwert, dass er keinen bemerkbaren Fehler verursachen würde, so kann die Störung außer acht gelassen werden, und eine Anpassung des Taktsignals für eine Störunterdrückung muss nicht zwingend durchgeführt werden. Bei einer nichtdetektierbaren Störung könnte der Analog/Digital-Wandler somit mit einem Taktsignal einer Taktsignalquelle arbeiten, welche auf einen festen Takt eingestellt ist.

Dabei ist in einer vorteilhaften Ausgestaltung die Taktfrequenz der ersten Taktsignalquelle auf eine im Wesentlichen konstante Frequenz eingestellt.

Um optimal auf eine Störung reagieren zu können, wird die Taktfrequenz der zweiten Taktsignalquelle auf eine veränderbare Frequenz eingestellt.

Um die Wandlungsergebnisse durch Schaltvorgänge des Schaltelementes nicht zusätzlich zu beeinträchtigen, ist es vorteilhaft, dass Taktsignal für den Analog/Digital-Wandler zwischen zwei Wandlungszyklen umzuschalten.

In einer optimierten Ausgestaltung des Verfahrens wird über eine Phasen-Regel-Schleife eine Phasenlage und damit zusammenhängend die angepasste Frequenz über einen geschlossenen Regelkreis so beeinflusst, dass eine möglichst kleine Phasenabweichung zwischen der Störfrequenz und der Frequenz für das Taktsignal erreicht wird. Da man nicht mit einer konstanten Abweichung der Netzfrequenz bzw. der Frequenz des Störsignals rechnen kann, wird die Anpassung der Frequenz und damit des Taktsignals geregelt.

Vorrichtungsgemäß wird für die eingangs genannte Vorrichtung die Aufgabe dadurch gelöst, dass das Mittel zur Erzeugung der Taktfrequenz ausgestaltet ist um die Taktfrequenz an eine Störfrequenz eines dem analogen Signal überlagerten Störsignals anzupassen. Eine Vorrichtung, wie sie z.B. durch eine Analog/Digital-Wandlerbaugruppe für die Erfassung von Messsignalen aus einem industriellen Prozess realisiert ist, ist diese vorteilhafter Weise mit einem Mittel zur Erzeugung einer Taktfrequenz ausgestaltet, welches es erlaubt, die Taktfrequenz an die jeweilig vorherrschenden Messbedingungen bzw. Störeinkopplungen bedarfsgerecht anzupassen. D.h. der für den Ablauf der Analog/Digital-Wandlung benötigte Takt (Clock) ist nicht mehr fest sondern kann variieren. Wie dem Fachmann bekannt ist, ist für die interne Abarbeitung in einem Analog/Digital-Wandler ein Takt (Clock) für die sequenzielle Abarbeitung erforderlich.

In einer Weiterbildung der Vorrichtung weist das Mittel einen Detektor auf, welcher mit dem Eingang in Verbindung steht und zumindest eine physikalische Größe des Störsignals ermittelt. Als physikalische Größen werden u.a. eine Frequenz des Störsignals und eine Amplitude des Störsignals angesehen.

Wird beispielsweise als physikalische Größe die Höhe einer Störspannung bzw. seine Maximalwerte herangezogen, so ist die Vorrichtung vorzugsweise dazu ausgestaltet, dass das Mittel weiterhin einen Komparator zum Vergleich der über den Detektor ermittelten Amplitude des Störsignals mit einem bestimmbaren Grenzwert aufweist.

Wenn das Störsignal detektiert ist, ist es zweckmäßig dass das Mittel ein Schaltelement aufweist, ausgestaltet zum Umschalten zwischen einer ersten Taktsignalquelle und einer zweiten Taktsignalquelle. Soll beispielsweise erst bei einer Störspannung mit einer Amplitude von 1 Volt mit einer Anpassung und somit mit einer Störunterdrückung reagiert werden, so wird über den Detektor die Störspannung erfasst und fortlaufend mittels des Komparators mit dem eingestellten Grenzwert von 1 Volt verglichen. Sollte dieser Grenzwert von 1 Volt überschritten werden, findet mittels des Schaltelementes ein Umschalten zwischen Taktsignalquellen mit unterschiedlichen Taktsignalen statt.

Dabei wirkt der Ausgang des Komparators derart mit dem Schaltelement zusammen, dass entweder die erste Taktsignalquelle oder die zweite Taktsignalquelle mit dem Analog/Digital-Wandler verbindbar ist.

Eine Steigerung der Verbesserung der Störunterdrückung wird dadurch erreicht, dass das Mittel eine elektronische Schaltungsanordnung aufweist, welche als eine Phasenregelschleife derart ausgestaltet ist, dass eine möglichst kleine Phasenverschiebung zwischen der Störfrequenz und der Taktfrequenz für das Taktsignal erreicht wird.

In einer optionalen Ausgestaltung ist die Schaltungsanordnung mit einem Datenbusausgang des Analog/Digital-Wandlers verbunden und weist einen Dateneingang auf, über welchem die Schaltungsanordnung parametrierbar ist und zusätzlich auf veränderbare Randbedingungen reagieren kann.

Bei beispielsweise Analog/Digital-Wandlungsbaugruppen mit mehreren Eingangskanälen ist es besonders vorteilhaft, dass durch das automatische Erkennen eines Störsignals und ein daraus resultierendes, beispielsweise Vervielfältigen der Störfrequenz und der Verwendung dieser vervielfältigen Störfrequenz als Taktsignal für den Analog/Digital-Wandler, eine höhere Störunterdrückung bei gleichzeitig schnellerer Wandlung in einen mehrkanaligen System zu erzielen ist. Insbesondere weil diese Idee die Verwendung eines Delta-Sigma Analog/Digital-Wandlers mit einem schnellen digitalen Filter erlaubt.

Es wird ebenfalls als Vorteil angesehen, dass beispielsweise ältere Analog/Digital-Wandlungsbaugruppen nachgerüstet werden können, nämlich durch Einbau einer zusätzlichen Schaltungsanordnung, wie sie zuvor beschrieben wurde. Eine Erweiterbarkeit von Analog/Digital-Baugruppen bzw. eine Nachrüstbarkeit ist somit gegeben.

Die Zeichnung zeigt ein Ausführungsbeispiel der erfindungsgemäßen Vorrichtung zur Umsetzung eines analogen Signals in ein digitales Signal, wobei auf dieser Vorrichtung das erfindungsgemäße Verfahren abläuft, dabei zeigen:
- FIG 1: eine Vorrichtung als Analog/Digital-Wandler und
- FIG 2: eine schematische Schaltungsanordnung.

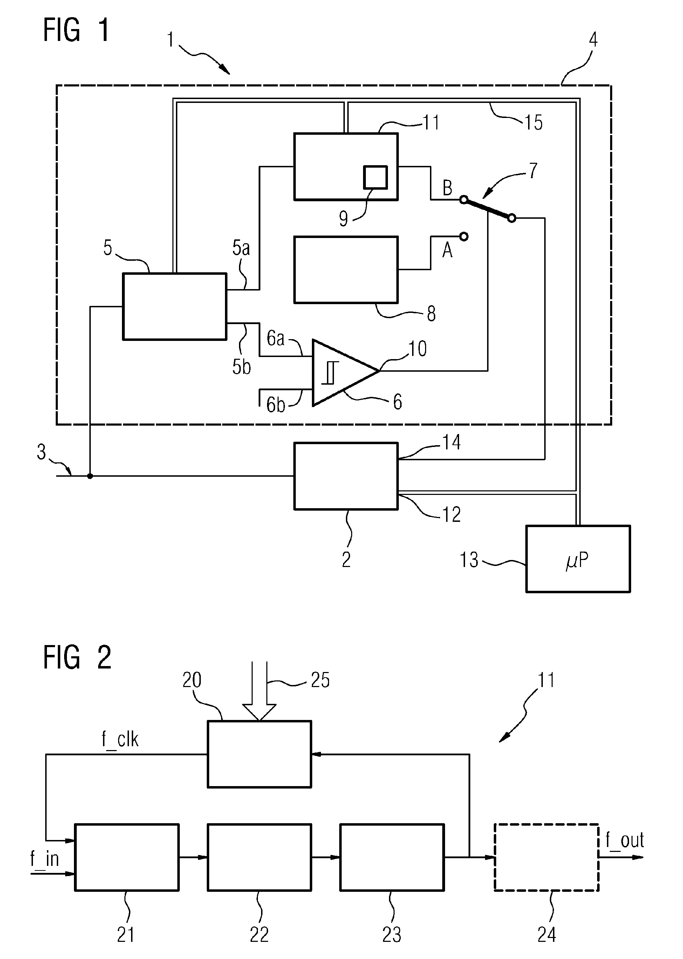

FIG 1 zeigt gemäß einem Blockschaltbild die Darstellung einer Vorrichtung 1 zur Umsetzung eines analogen Signals in ein digitales Signal. Das analoge Signal wird über einen Eingang 3 an den Analog/Digital-Wandler 2 geführt. Die Vorrichtung 1 umfasst einen Datenbus 15, wobei der Datenbus 15 einen Detektor 5 zum Detektieren eines Störsignals, eine Schaltungsanordnung 11 und einen Mikroprozessor 13 mit einem Datenbusausgang 12 des Analog/Digital-Wandlers 2 verbindet.

Ein über den Eingang 3 eingespeistes analoges zu messendes Signal wird innerhalb des Analog/Digital-Wandlers 2 in ein digitales Signal gewandelt und über den Datenbusausgang 12 an den Mikroprozessor 13 weitergeleitet. Ein für einen Analog/Digital-Wandler 2 notwendiges Taktsignal wird in einem Mittel 4 zur Erzeugung einer Taktfrequenz generiert. Dieses Mittel 4 ist schematisch als ein gestrichelter Kasten um die bereits erwähnten Schaltungskomponenten angeordnet, da Analog/Digital-Wandler nach dem Stand der Technik als Mittel zur Erzeugung einer Taktfrequenz nur einen fest eingestellten Frequenzoszillator aufweisen. Erfindungsgemäß ist das Mittel 4 dahingehend erweitert, dass es nun einen Detektor 5, einen Komparator 6, ein Schaltelement 7 mit einer ersten Schaltstellung A und einer zweiten Schaltstellung B, eine erste Taktsignalquelle 8 und eine innerhalb der Schaltungsanordnung 11 angeordnete zweite Taktsignalquelle 9 aufweist.

Der Detektor 5 ist als ein Frequenzdecoder ausgestaltet und über eine Signalleitung mit dem Eingang 3 verbunden. Als Eingangssignal erhält der Detektor 5 somit das über den Eingang 3 geführte analoge Signal. Der Detektor 5 ist dazu ausgebildet, eine Störung auf einem Gleichsignal zu erkennen. Dazu weist der Detektor 5 einen Frequenzausgang 5a und einen Amplitudenausgang 5b auf. An dem Frequenzausgang 5a wird eine Frequenz als Eingangsgröße für die Schaltungsanordnung 11 bereitgestellt. An dem Amplitudenausgang 5b wird ein Spannungswert als Eingangsgröße für den Komparator 6 an einen ersten Komparatoreingang 6a bereitgestellt. An einem zweiten Komparatoreingang 6b liegt ein Grenzwert an, welcher bei Überschreitung einen Ausgang 10 des Komparators 6 aktiviert. Der aktivierte Ausgang 10 steht mit dem Schaltelement 7 in Verbindung und sorgt dafür, dass das Schaltelement 7 von der ersten Schaltstellung A in die zweite Schaltstellung B schaltet.

In der ersten Schaltstellung A ist der Analog/Digital-Wandler 2 mit seinem Takteingang 14 mit der ersten Taktsignalquelle 8 verbunden und in der zweiten Schaltstellung B ist der Takteingang 14 mit der zweiten Taktsignalquelle 9 verbunden.

Hat der Detektor 5 eine Störung detektiert und über den Komparator 6 eine Umschaltung von der ersten Schaltstellung A in die zweite Schaltstellung B veranlasst, so wird ein innerhalb der Schaltungsanordnung 11 realisierter Phasenregelkreis tätig. Die benötigte Anpassung der Taktfrequenz an die Störfrequenz des analogen Signals wird nun mittels der Phasenregelschleife kontinuierlich angepasst und damit eine Störunterdrückung verbessert.

Gemäß FIG 2 ist die Schaltungsanordnung 11 in einer Blockschaltbilddarstellung detaillierter dargestellt. Ein Phasendetektor 21 erhält als Eingangsgröße eine Frequenz f_in. Die Frequenz f_in ist die Frequenz, welche am Frequenzausgang 5a des Detektors 5 aus FIG 1 anliegt. Als Ausgangsgröße gibt der Phasendetektor 21 seinen zuvor bestimmten Wert an einen Filter 22 weiter. Der Filter 22 speist einen variablen Oszillator 23, wobei dieser als Ausgangsgröße eine Ausgangsfrequenz f_out bereitstellt. Optional kann in dem Ausgangszweig noch eine optionale Teilerschaltung 24 angeordnet sein. Die Teilerschaltung 24 kann eine geregelte Frequenz nochmals herunterteilen bzw. eine andere Frequenz bereitstellen.

Die von dem variablen Oszillator 23 generierte Frequenz wird in einer Regelschleife zurückgeführt, dabei trifft sie auf eine Teilerschaltung 20 und diese Teilerschaltung 20 liefert einen Takt f_clk als zweite Eingangsgröße für den Phasendetektor 21.

Die Teilerschaltung 20 ist mit einem Parametereingang 25 ausgestaltet. Über diesen Parametereingang 25 können der Schaltungsanordnung 11 über den in FIG 1 beschriebenen Datenbus 15 neue Konfigurationsparameter für die Schaltungsanordnung 11 bereitgestellt werden. Diese Konfigurationsparameter werden vorzugsweise in dem Mikroprozessor 13 berechnet. Es wird vorzugsweise eine Schaltungsanordnung mit einer PLL-Schaltung (Phase-locked loop Schaltung) erster, insbesondere zweiter, insbesondere höherer Ordnung eingesetzt.

Ein weiterer Vorteil ist, dass die PLL-Schaltung sowohl unabhängig von dem Analog-Digital-Wandler 2 extern mit beispielsweise einen ASIC-Baustein aufgebaut werden kann, als auch zusammen mit dem Analog-Digital-Wandler 2 in Siliziummaterial auf einem Substrat in einem Gehäuse implementiert werden kann. Der Vorteil dieser integrierten Implementierung liegt in einer Abstimmung zwischen den Registern, die den Analog-Digital-Wandler 2 und seine digitalen Filter steuern, da hier ein zeitliches Verhalten berücksichtigt werden muss und dadurch ebenfalls optimiert werden kann. Mit einer solchen optimierten Ausgestaltung können schnellere Wandlungszeiten erzielt werden.

Vorteilhafter Weise wird diese Ausgestaltung der Schaltungsanordnung auf die Null-Stellen-Frequenz angepasst.

## Patentansprüche

1. Verfahren zur Umsetzung eines analogen Signals in ein digitales Signal, wobei das analoge Signal über einen Eingang (3) eines Analog/Digital-Wandlers (2) abgetastet wird, und das abgetastete Signal in das digitale Signal umgesetzt wird, wobei mit einer Taktfrequenz eine Umsetzungszeit bestimmt wird,
**dadurch gekennzeichnet, dass** die Taktfrequenz an eine Störfrequenz eines dem analogen Signal überlagerten Störsignals angepasst wird, und die angepasste Taktfrequenz zur Folge hat, dass die Umsetzungszeit derart angepasst wird, dass bei der Umsetzung das Störsignal unterdrückt wird.

2. Verfahren nach Anspruch 1, wobei aus der Taktfrequenz ein Taktsignal erzeugt wird, und das Taktsignal in Abhängigkeit vom Störsignal ermittelt wird.

3. Verfahren nach Anspruch 1 oder 2, wobei eine Amplitude des Störsignals ermittelt wird.

4. Verfahren nach Anspruch 3, wobei in Abhängigkeit der Amplitude ein Schaltelement (7) betätigt wird, und mittels des Schaltelements (7) dem Analog/Digital-Wandler entweder aus einer ersten Taktsignalquelle (8) oder aus einer zweiten Taktsignalquelle (9) das Taktsignal zugeführt wird.

5. Verfahren nach Anspruch 4, wobei die Taktfrequenz der ersten Taktsignalquelle (8) auf eine im Wesentlichen konstante Frequenz eingestellt wird.

6. Verfahren nach Anspruch 4 oder 5, wobei die Taktfrequenz der zweiten Taktsignalquelle (9) auf eine veränderbare Frequenz eingestellt wird.

7. Verfahren nach einem der Ansprüche 4 bis 6, wobei das Schaltelement (7) zu einem Zeitpunkt betätigt wird, der sich zwischen zwei Umsetzzeiten befindet.

8. Verfahren nach einem der Ansprüche 2 bis 7, wobei über eine Phasenregelschleife eine Phasenlage und damit zusammenhängend die angepasste Frequenz über einen geschlossenen Regelkreis so beeinflusst wird, dass eine möglichst kleine Phasenabweichung zwischen der Störfrequenz und der Frequenz für das Taktsignal erreicht wird.

9. Vorrichtung (1) zur Umsetzung eines analogen Signals in ein digitales Signal umfassend,
- einen Analog/Digital-Wandler (2),
- einen Eingang (3) für ein analoges Signal,
- ein Mittel (4) zur Erzeugung einer Taktfrequenz,
**dadurch gekennzeichnet, dass** das Mittel (4) zur Erzeugung der Taktfrequenz ausgestaltet ist um die Taktfrequenz an eine Störfrequenz eines dem analogen Signal überlagerten Störsignals anzupassen.

10. Vorrichtung (1) nach Anspruch 9, wobei
das Mittel (4) einen Detektor (5) aufweist, welcher mit dem Eingang (3) in Verbindung steht und zumindest eine physikalische Größe des Störsignals ermittelt.

11. Vorrichtung (1) nach Anspruch 9 oder 10, wobei das Mittel (4) weiterhin einen Komparator (6) zum Vergleich einer über den Detektor (5) ermittelten Amplitude des Störsignals mit einem bestimmbaren Grenzwert aufweist.

12. Vorrichtung (1) nach einem der Ansprüche 9 bis 11, wobei das Mittel (4) ein Schaltelement (7) aufweist, ausgestaltet zum Umschalten zwischen einer ersten Taktsignalquelle (8) und einer zweiten Taktsignalquelle (9).

13. Vorrichtung (1) nach Anspruch 11 oder 12, wobei ein Ausgang (10) des Komparators (6) derart mit dem Schaltelement (7) zusammenwirkt, das entweder die erste Taktsignalquelle (8) oder die zweite Taktsignalquelle (9) mit dem Analog/Digital-Wandler (2) verbindbar ist.

14. Vorrichtung (1) nach einem der Ansprüche 9 bis 13, wobei das Mittel (4) eine elektronische Schaltungsanordnung (11) aufweist, welche als eine Phasenregelschleife derart ausgestaltet ist, dass eine möglichst kleine Phasenabweichung zwischen der Störfrequenz und der Taktfrequenz für das Taktsignal erreicht wird.

15. Vorrichtung (1) nach Anspruch 14, wobei die Schaltungsanordnung (11) mit einem Datenbusausgang (12) des Analog/Digitalwandlers (2) in Verbindung steht und hierüber parametrierbar ist.
